# EUROPEAN PATENT SPECIFICATION

(11) **EP 0 564 145 B1**
(45) Date of publication and mention of the grant of the patent: **03.02.1999**
(21) Application number: 93302199.0
(22) Date of filing: 23.03.1993
(51) Int. Cl.: H04N 7/01, H03H 17/06

(54) **Sampling rate converter**
Abtastfrequenzumwandler
Convertisseur de fréquence d'échantillonage

(30) Priority: 31.03.1992 JP 105978/92
(43) Date of publication of application: 06.10.1993
(73) Proprietor: SONY CORPORATION, Tokyo (JP)
(72) Inventor: Iwata, Eiji, c/o Patents Division, Shinagawa-ku, Tokyo 141 (JP); Yamazaki, Takao, c/o Patents Division, Shinagawa-ku, Tokyo 141 (JP)
(74) Representative: Williams, Janice

(56) References cited:
- EP-A- 0 390 531
- EP-A- 0 443 945
- PATENT ABSTRACTS OF JAPAN vol. 13, no. 240 (E-767) 6 June 1989 & JP-A-01 042 909 (SONY CORPORATION) 15 February 1989

## Description

This invention relates to a sampling rate converter, and is particularly suitable for converting sampling frequencies of digital signals in two-way.

Heretofore, for example, it is necessary that video signals and audio signals which are digital signalized with the predetermined format are converted to the other different format. In this case, if sampling frequencies (L, M) of digital signals are different each other, sampling frequencies (L, M) of digital signals must be converted from a sampling frequency L to a sampling frequency M or, in contrast with this, to convert from a sampling frequency M to a sampling frequency L.

An apparatus for converting sampling frequencies is called as a sampling rate converter. U.S. Patent No. 5,159,339 of the applicant of this application discloses a sampling rate converter, comprising an oversampling filter with filter coefficient generation means. Functions and uses are explained in detail in this Patent.

Further, the sampling rate converter is generally consisted of a digital filter, an example of which is, for example, disclosed in Japanese Patent Application Laid-Open No. 42,909/89 of the applicant of this application. Thus, the sampling rate converter constituted by a digital filter is known in the prior art.

Theoretically, a filter coefficient which is obtained in the case of converting the sampling frequency from the frequency M to the frequency L in utilizing the sampling rate converter, i.e., when converting by L/M times (hereinafter referred to as M:L conversion), can be the same which is obtained in the case of converting the sampling frequency from the frequency L to frequency M, i.e., when converting by M/L times (hereinafter referred to as L:M conversion).

However, in thus constructed sampling rate converter, when the sampling rate is changed, the outputs (DC gain) in the case where direct current components (DC) are inputted in the sampling rate converter fluctuate on every outputting. This is because of the quantization error when the filter coefficient is quantized.

Therefore, it is necessary to amend the value of filter coefficients after quantization in order to keep these changes based on the DC gain to be constant. In the conventional sampling rate converter, for example, when the filter coefficients are operated in order that the DC gain at the M:L conversion is constant in all phases, the DC gain can not become constant at the L:M conversion.

Accordingly, the filter coefficient on the M:L conversion differs from the same on L:M conversion, and in order to realize the sampling rate converter which can both M:L convert and L:M convert, it becomes necessary to have two independent sets of filter coefficients for the respective conversions. After all, in the case where only one set of filter coefficients is available based on the hardware restrictions, it becomes a problem that the DC gain is not constant in either conversion periods.

According to the present invention there is provided a sampling rate converter which comprises digital filters for converting a sampling frequency L of a digital signal to a sampling frequency M (L:M conversion) or for converting a sampling frequency M of a digital signal to a sampling frequency L (M:L conversion), while utilizing the same filter coefficients and maintaining a constant predetermined DC gain for both conversions, said sampling rate converter comprising: an over-sampler for multiplying said sampling frequency L or M by M or L, respectively, during said L:M conversion and said M:L conversion, respectively; a rate converting filter receiving an output of said over-sampler for restricting the frequency band of said output; a central processing unit (CPU) for supplying filter coefficients to said rate converting filter and having means for quantizing said filter coefficients, means for arranging the quantized filter coefficients into a three-dimensional array including rows and columns, the ratio of number of rows to number of columns depending on the ratio of said first sampling frequency L and said second sampling frequency M, means for determining a ratio between a total sum of values of said rows and columns of the array of quantized filter coefficients, and means for correcting each of said quantized filter coefficients in response to the determined ratio so as to maintain said predetermined DC gain; and a down-sampler receiving an output of said rate converting filter for multiplying the rate converted frequencies.

In embodiments of the invention the filter coefficients W to be given to digital filters are arranged into arrays wℓ_{,m}(k), Eℓ_{,m}(k) corresponding to the first and second sampling frequencies L and M on the basis of the specific rule, and the total sum S_{L}(ℓ) in the direction of row in which numbers corresponding to the first sampling frequency L exist will be equalized in the coefficient arrays wℓ_{,m}(k), Eℓ_{,m}(k) and the total sum S_{M}(m) in the direction of column in which numbers corresponding to the second sampling frequency M exist will be equalized to give as the filter coefficients W.

Since filter coefficients are arranged on the arrays wℓ_{,m}(k), Eℓ_{,m}(k) corresponding to the first and the second sampling frequencies L and M on the basis of the specific rule and the total sums of row and column S_{L}(ℓ) and S_{M}(m) in coefficient arrays wℓ_{,m}(k) Eℓ_{.m}(k) are operated to become equal so as to give the filter coefficients W, the DC gain on conversion in the case where the sampling rate is converted in two-way with a set of filter coefficients W can be kept constant.

Thus, embodiments of this invention provide a sampling rate converter capable of keeping the DC gain constant at the time of conversion even in the case of converting the sampling rate in two-way directions with a set of filter coefficients.

Embodiments of the invention will now be described, by way of example, with reference to the accompanying drawings in which:
Fig. 1 is a flow chart showing an algorithm of one embodiment of the Magic Square DC Gain Matching for obtaining filter coefficients of a sampling rate converter embodying the present invention;
Fig. 2 is a flow chart showing an algorithm of the sub-filter DC gain matching at the first subroutine of the Magic Square DC Gain Matching algorithm in Fig. 1;
Fig. 3 is a flow chart showing an algorithm of the sub-filter DC gain matching at the second subroutine of the Magic Square DC Gain Matching algorithm in Fig. 1;
Fig. 4 is a flow chart showing an algorithm of the sub-filter DC gain matching at the third subroutine of the Magic Square DC Gain Matching algorithm in Fig. 1;
Fig. 5 is a flow chart showing an algorithm of the sub-filter DC gain matching as same as Fig. 4;
Fig. 6 is a flow chart showing an algorithm of the sub-filter DC gain matching as same as Fig. 4;
Fig. 7 is a flow chart showing an algorithm of the sub-filter DC gain matching as same as Fig. 4;
Fig. 8 is a flow chart showing an algorithm of the sub-filter DC gain matching as same as Fig. 4;
Fig. 9 is a schematic view for explanation of the operation method for obtaining the filter coefficients by applying the Magic Square DC Gain Matching algorithm in Fig. 1;
Fig. 10 is a signal waveform charts for explanation of the principle of sampling rate conversion according to an embodiment of the present invention;
Fig. 11 is a block diagram showing the construction of one embodiment of a sampling rate converter according to the present invention.

### (1) Principle of Sampling Rate Conversion

The principle of sampling rate conversion in response to the multi-rate digital signal processing applied to this embodiment will be discussed in the following paragraph. At first, a sampling rate of digital signals is converted by L/M times, i.e., the case where a sampling rate is converted to the M:L conversion. At this point, the sampling frequency after conversion f'_{S} can be expressed using the sampling frequency before conversion f_{S} as follows:${\text{f'}}_{\text{S}} \text{=} \frac{\text{L}}{\text{M}} {\text{f}}_{\text{S}}$

This M:L conversion is realized after the input list x(n) by sampling frequency f_{S} is over-sampled by L times and down converted by 1/M times. Practically, in the case where M is bigger than L (M > L), it is called "down conversion", and in the case where M is smaller than L (M < L), it is called "up conversion".

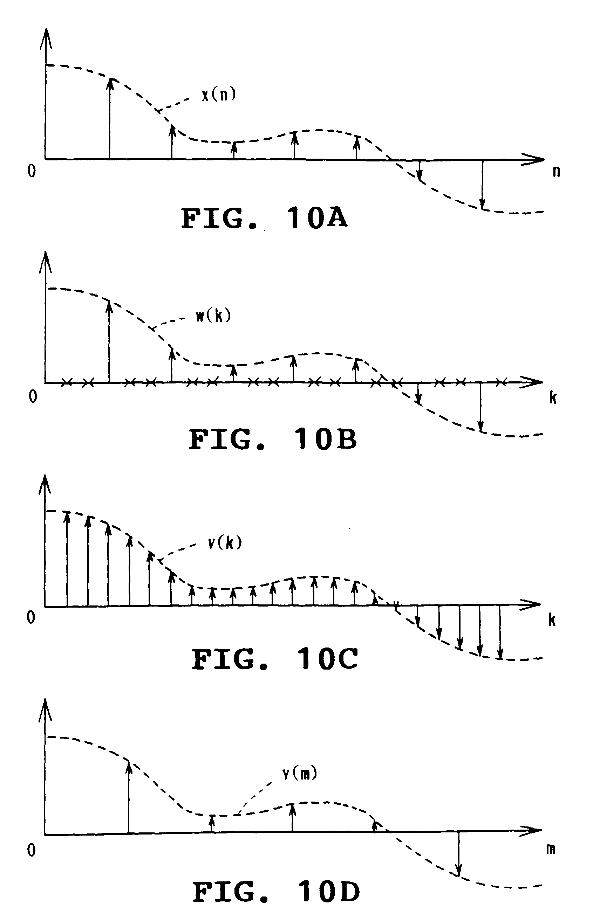

Figs. 10A to 10D are signal waveform charts for explanation of the principle of sampling rate conversion applying to this embodiment. Figs. 10A to 10D show the M:L conversion in the case where "M = 4" and "L = 3", and the process of M:L conversion are explained. As Fig. 10A shows, a list sampled the initial signals by the sampling frequency f_{S} becomes x(n) and is an input list of M:L conversion.

As shown in Fig. 10B, the input list x(n) is over sampled by L times. At this point, "L - 1" numbers of zero samples (samples with "0" values) are inserted at equal intervals among samples of the input list x(n), and this becomes the list w(k). The sampling frequency of this list w(k) is "L . f_{S}".

Furthermore, as shown in Fig. 10C, the list w(k) is covered with the low-pass filter constituted by digital filters to restrict band to min (f_{S}/2, f'_{S}/2) and make this an output list of low-pass filter as v(k).

Moreover, as shown in Fig. 10D, the list which is down converted by 1/M times from the low-pass filter output list v(k) becomes an output list y(m). The sampling frequency of this output list y(m) is "(L/M) · f_{S} = (f'_{S})".

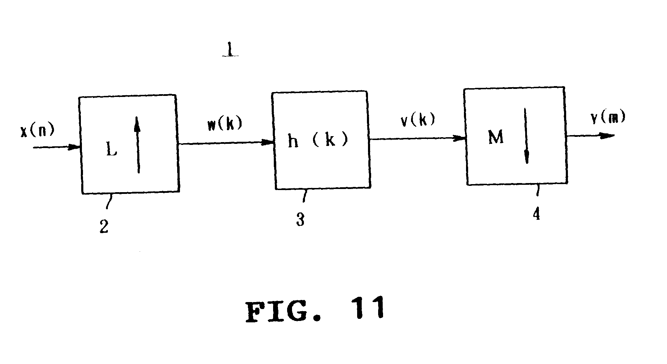

The constitution of one embodiment of the sampling rate converter according to this invention is shown by a block diagram in Fig. 11. This M:L conversion is constituted by an over-sampler 2, a rate converting filter 3 and a down-sampler 4. The low-pass filters as described above in Fig. 10C is referred to as a rate converting filter 3.

It is apparent from Figs. 10A to 10D that the output list y(m) is one of the values wherein the phase of input list x(n) is delayed by "360/L" degrees (there are "L" numbers). The filter for obtaining these values respectively is called a sub-filter. The coefficient of sub-filter is a subset consisting of values of every L coefficients of the rate converting filter 3.

### (2) Condition of Sampling Rate Converter

The condition for setting the coefficients of the rate converting filter 3 in the case where a sampling rate converter 1 is planned will be described as follows: Where the coefficients of the rate converting filter 3 are "aₙ" (n = 0, 1, 2... N-1). To simplify the matter, an order of the rate converting filter 3 is "N = j · M · L" ("j" is a natural number).

In the first place, the coefficients of the rate converting filter 3 are divided into respective groups, for the sub-filter coefficient of M:L conversion and the sub-filter coefficient of L:M conversion. With this arrangement, there are L sets of M:L conversion sub-filter coefficients and an order "Nₚℓ" becomes "Nₚℓ" = N/L". At this point, the M:L conversion sub-filter coefficient in "i" th is expressed in the following equation.${\text{A}}_{\text{L}} {\text{(i) = [a}}_{\text{i}} {\text{, a}}_{\text{L+i}} {\text{, a}}_{\text{2L+i}} {\text{, ..., a}}_{\text{N-L+i}} \text{]}$ (where i = 0, 1, 2, ..., L-1)

On the other hand, there are M sets of L:M conversion sub-filter coefficients and an order "Nₚₘ" becomes "Nₚₘ = N/M". At this point, the L:M conversion sub-filter coefficient in "i"th is defined as follows:${\text{A}}_{\text{M}} {\text{(i) = (a}}_{\text{i}} {\text{, a}}_{\text{M+i}} {\text{, a}}_{\text{2M+i}} {\text{, ..., a}}_{\text{N-M+i}} \text{]}$ (where i = 0, 1, 2, ..., M-1)

At this point, the conditions which can be expressed in the following equations are given to coefficients of the M:L conversion sub-filter and the L:M conversion sub-filter. 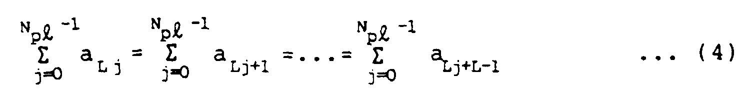 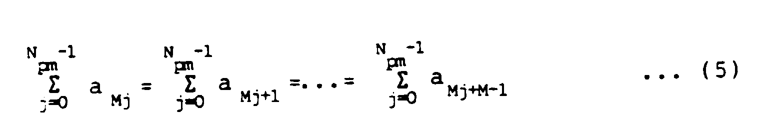 If the coefficients of the rate converting filter 3 satisfy the conditions described above in both equations (4) and (5), it is possible to use the same coefficient of rate converting filter 3, not only in the M:L conversion but also in the L:M conversion.

### (3) Magic Square DC Gain Matching

In case of sampling rate converter 1 of this embodiment, the filter coefficients are operated in order that the DC gain becomes constant both in M:L converting and L:M converting in utilizing an algorithm called Magic Square DC Gain Matching. As a result, a set of filter coefficients can be held in common in case of realizing both M:L conversion and L:M conversion.

First of all, an algorithm of the Magic Square DC Gain Matching is explained. The object of the operation is a filter coefficient after quantization "a_{q}(n)" (n = 0, 1, 2..., N-1) and where a quantization error between coefficients before quantization a(n) is e_{q}(n) ( = a(n) - a_{q}(n)).

This algorithm is designed in order to minimize the increase of quantization errors by the DC Gain Matching. To simplify the matter the filter order is "N = j · M · L" ("j" is a natural number). Also, assuming the coefficient standardization in case of quantization operation is performed in order to satisfy the following equation: 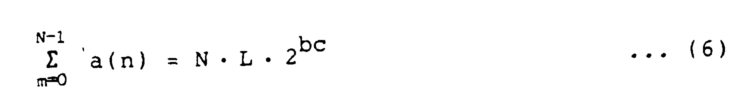 Where "bc" is a bit length of the coefficients.

### (3-1) Preparation for Magic Square DC Gain Matching

As preparation for the Magic Square DC Gain Matching, the filter coefficient a_{q}(n) after quantization is substituted for a three dimensional array defined in the following equation: 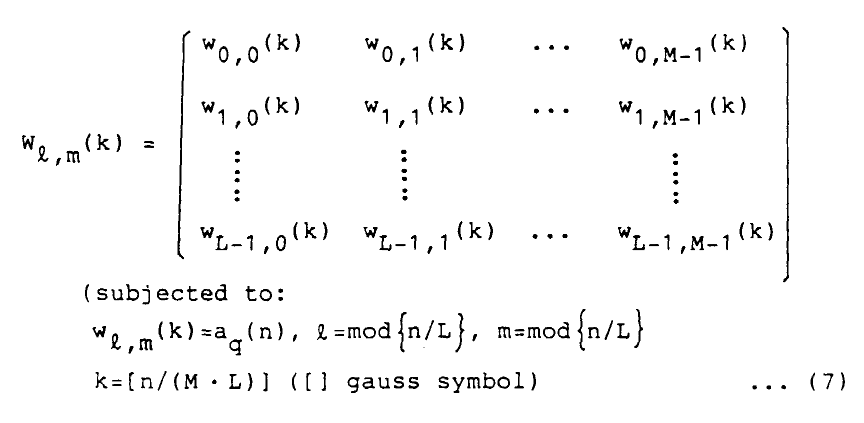 and simultaneously, the quantization error e_{q}(n) is substituted for a three dimensional array Eℓ_{,m}(k).

Then, obtain the total sum S_{L}(ℓ) of L numbers of M:L conversion sub-filter coefficients in the following equation: 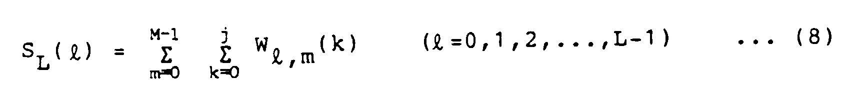 In the similar way, obtain the total sum S_{M}(m) of M numbers of L:M conversion sub-filter coefficients in the following equation:

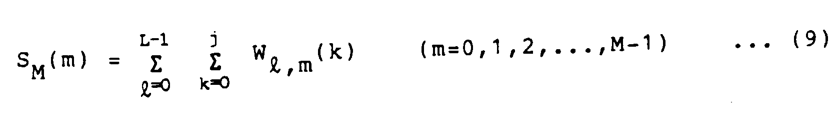

At this point, in order to keep the DC level constant, the conditions to be expressed in the following equation will be applied to the M:L conversion sub-filter rather than equations (4) and (6) stated above:${\text{S}}_{\text{L}} {\text{(0)=S}}_{\text{L}} {\text{(1)=S}}_{\text{L}} {\text{(2)=...=S}}_{\text{L}} {\text{(L-1)=M·2}}^{\text{bc}}$

In the similar way, regarding the L:M conversion sub-filter, the conditions to be described in the following equation will be applied rather than equation (5) and (6) stated above:${\text{S}}_{\text{M}} {\text{(0)=S}}_{\text{M}} {\text{(1)=S}}_{\text{M}} {\text{(2)...=S}}_{\text{M}} {\text{(M-1)=L 2}}^{\text{bc}}$

Accordingly, if the array element wℓ_{,m}(k) can be manipulated to satisfy two conditions of equations (10) and (11) stated above simultaneously, the DC level can be constant in both ways of the M:L conversion sub-filter and the L:M conversion sub-filter.

Such operation is called the magic square DC gain matching because of forming the array that respective sums of number in direction of column and row are constantly equalized. The target value and errors of respective coefficients of the M:L conversion sub-filter and L:M conversion sub-filter are defined for performing this operation in the following equations:${\text{d}}_{\text{L}} {\text{(ℓ)=M·2}}^{\text{bc}} {\text{-S}}_{\text{L}} \text{(ℓ) (ℓ=0,1,2...,L-1)}$${\text{d}}_{\text{M}} {\text{(m)=L·2}}^{\text{bc}} {\text{-S}}_{\text{M}} \text{(ℓ) (m=0,1,2...,M-1)}$

d_{L}(ℓ), d_{M}(m) of the equations (12) and (13) are called error sequences. Regarding error sequences d_{L}(ℓ) and d_{M}(m), the following equation can be defined:

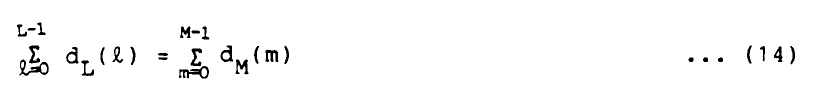

### (3-2) Algorithm of Magic Square DC Gain Matching

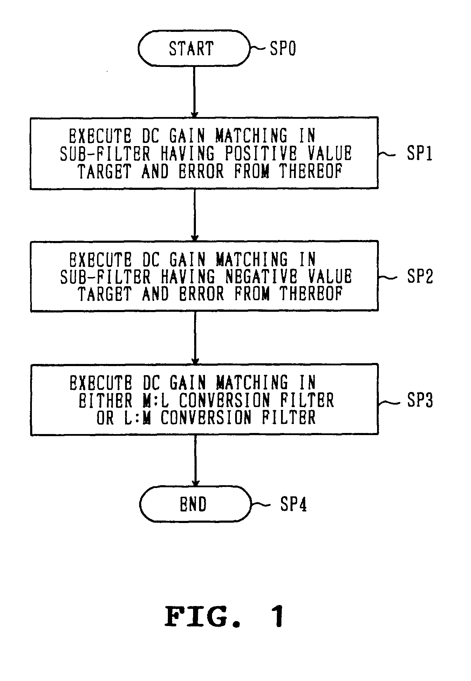

At this point, the magic square DC gain matching process is performed in the computer system including CPU, and when the magic square DC gain matching process is designated, the CPU executes an algorithm of the magic square DC gain matching processing program SP0 as shown in Fig. 1.

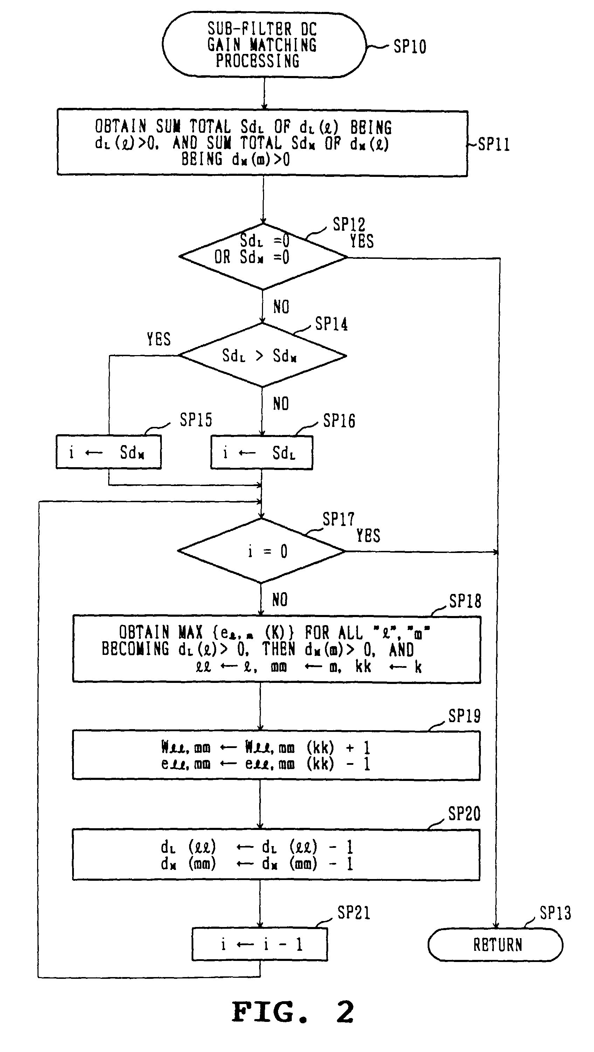

More specifically, the CPU enters from the magic square DC gain matching processing program SP0, and at the next step SP1, as shown in Fig. 2, executes a subroutine of the first sub-filter DC gain matching processing program SP10 in order to execute the DC gain matching in the sub-filter having the positive value error from the target value.

Practically, at the first sub-filter DC gain matching processing program SP10, the DC gain matching is performed in the sub-filter having the positive value error from the target value, i.e., the sub-filter having the smaller total sum of coefficients than the target value, as follows.

More specially, the CPU enters from the step SP10 and at a step SP11, obtains the total sums S_{dL} and S_{dM} regarding each of the error sequences d_{L}(ℓ), d_{M}(m) with positive values. Then, at a step SP12, if at least one of the total sums S_{dL}, S_{dM} are zero, the CPU moves to a step SP13 and terminates the sub-filter DC gain matching processing program SP10 and returns to the magic square DC gain matching processing program SP0.

Furthermore, the CPU executes steps SP14 - SP16 and selects one of the total sums S_{dL}, S_{dM} which has the smaller absolute value to decide the absolute value to "i" (if both absolute values are the same, either one will be acceptable). Then, the CPU executes steps SP17 - SP21 until this "i" becomes "0" and obtains max (eℓ_{,m}(k)) of all "ℓ" and "m" having the total sums "d_{L}(ℓ) > 0" and "d_{M}(m) > 0" and performs the calculations in the following equations, where "ℓ", "m" and "k" with the maximum values are "ℓℓ", "mm" and "kk", respectively:${\text{W}}_{\text{ℓℓ,mm}} {\text{(kk) = W}}_{\text{ℓℓ,mm}} \text{(kk)+1}$${\text{e}}_{\text{ℓℓ,mm}} {\text{(kk) = e}}_{\text{ℓℓ,mm}} \text{(kk)-1}$${\text{d}}_{\text{L}} {\text{(ℓℓ) = d}}_{\text{L}} \text{(ℓℓ)-1}$${\text{d}}_{\text{M}} {\text{(mm) = d}}_{\text{M}} \text{(mm)-1}$ then, "i = i - 1" is performed, and when "i" becomes "0", the CPU moves from the step SP17 to the step SP13 and terminates said sub-filter DC gain matching processing program SP10 and returns to the magic square DC gain matching processing program SP0.

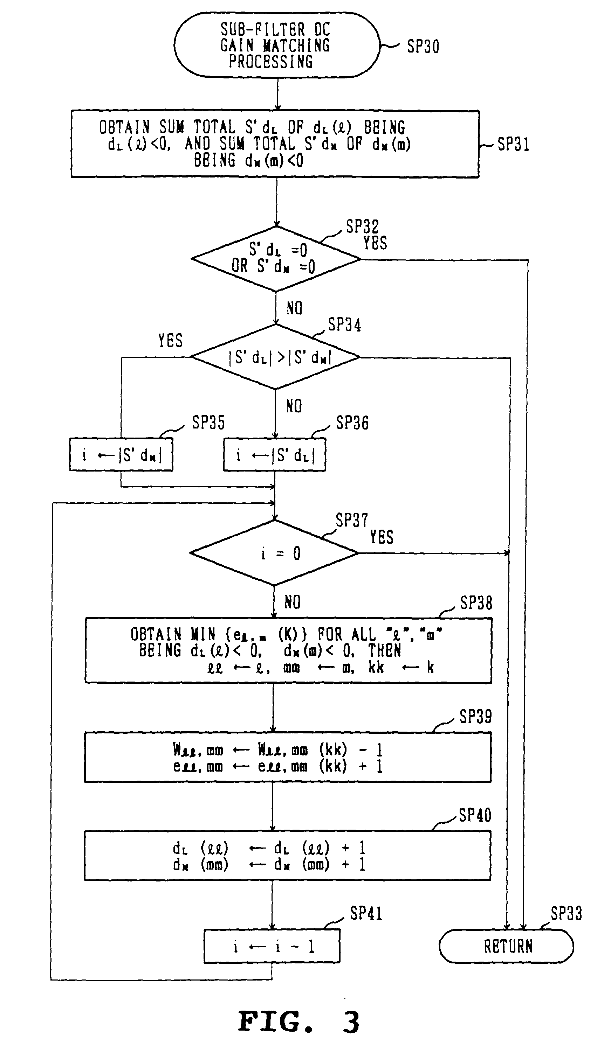

Then, at the step SP2 of the magic square DC gain matching processing program SP0, the CPU executes a subroutine of the second sub-filter DC gain matching processing program SP30 in order to execute the DC gain matching regarding the sub-filters which have negative value errors from the target value as shown in Fig. 3.

More specifically, the CPU enters from the step SP30 and at the step SP31, obtains the total sums S'_{dL}, S'_{dM} having negative values regarding each of the error sequences d_{L}(ℓ) and d_{M}(m). Then at the step SP32, if at least one of the total sums S'_{dL}, S'_{dM} is zero, the CPU moves to the step S33, finishes the second sub-filter DC gain matching processing program SP30 and returns to the magic square DC gain matching processing program SP0.

Also, the CPU executes the step SP34 - step SP36 and selects the one which has the smaller absolute value in the total sums S'_{dL}, S'_{dM} and that absolute value is decided to "i" (if the absolute values are the same, either one will be acceptable). The relations between the total sums S_{dL} and S_{dM} utilized in the DC gain matching operation of the first sub-filter DC gain matching processing program SP10 on the basis of the equation (14) and the total sums S'_{dL} and S'_{dM} obtained at this time are expressed as follows:${\text{S}}_{\text{dL}} {\text{> S}}_{\text{dM}} \text{then} \left|{\text{S'}}_{\text{dL}}\right| \text{>} \left|{\text{S'}}_{\text{dM}}\right|$${\text{S}}_{\text{dL}} {\text{< S}}_{\text{dM}} \text{then} \left|{\text{S'}}_{\text{dL}}\right| \text{<} \left|{\text{S'}}_{\text{dM}}\right|$ Accordingly, if the total sums S_{dL} is selected at the step SP14 - SP16 of the DC gain matching operation of the first sub-filter DC gain matching processing program SP10 for example, the sum totals S'_{dL} will positively be selected at this point.

Then, the CPU executes the step SP38 - step SP41 until "i" obtained as stated above becomes "0" and obtains min (e_{ℓ,m}(k)) of all "ℓ" and "m" having the total sums "d_{L}(ℓ) < 0" and "d_{M}(m) < 0" and executes the calculation on the following equations where "ℓ", "m" and "k" with the minimum values are "ℓℓ", "mm" and "kk", respectively,${\text{W}}_{\text{ℓℓ,mm}} {\text{(kk) = W}}_{\text{ℓℓ,mm}} \text{(kk)-1}$${\text{e}}_{\text{ℓℓ,mm}} {\text{(kk) = e}}_{\text{ℓℓ,mm}} \text{(kk)+1}$${\text{d}}_{\text{L}} {\text{(ℓℓ) = d}}_{\text{L}} \text{(ℓℓ)+1}$${\text{d}}_{\text{M}} {\text{(mm) = d}}_{\text{M}} \text{(mm)+1}$ then, "i = i - 1" is performed, and when "i" becomes "0", the CPU moves to the step SP33 and stops said second sub-filter DC gain matching processing program SP30, and returns to the magic square DC gain matching processing program SP0.

At this point, all elements of either one of the error sequences d_{L}(ℓ) and d_{M}(m) become zero; i.e., the DC gain matching on either one of the sub-filters has been completed.

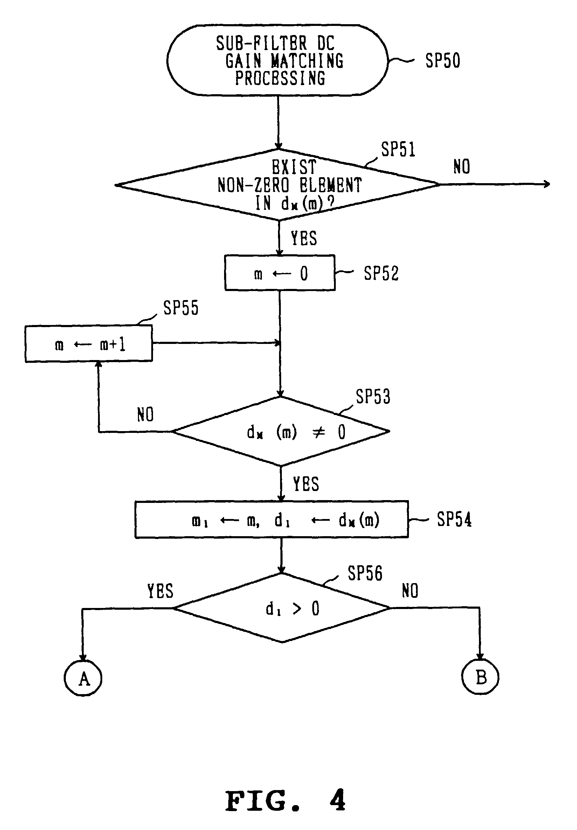

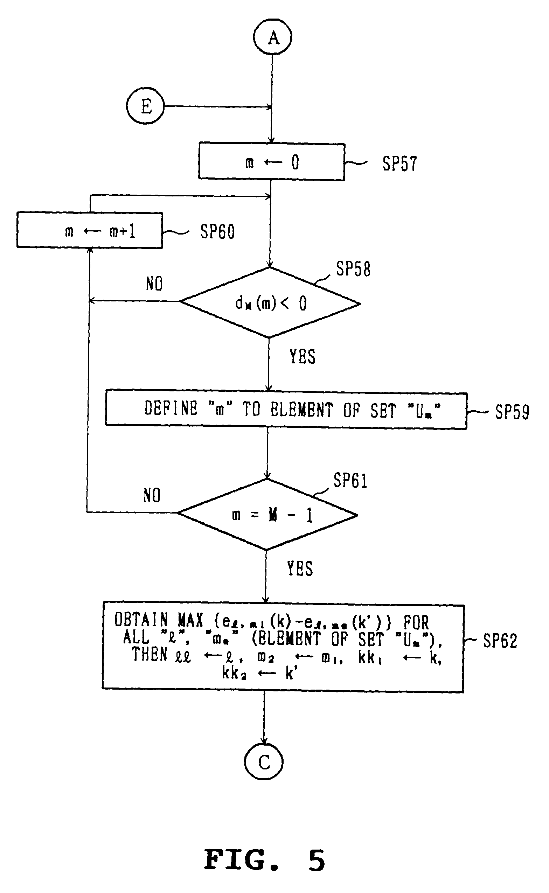

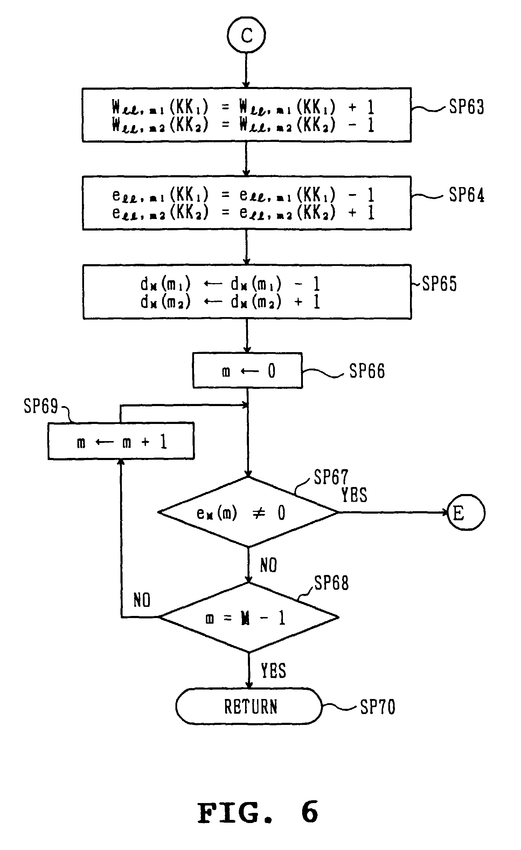

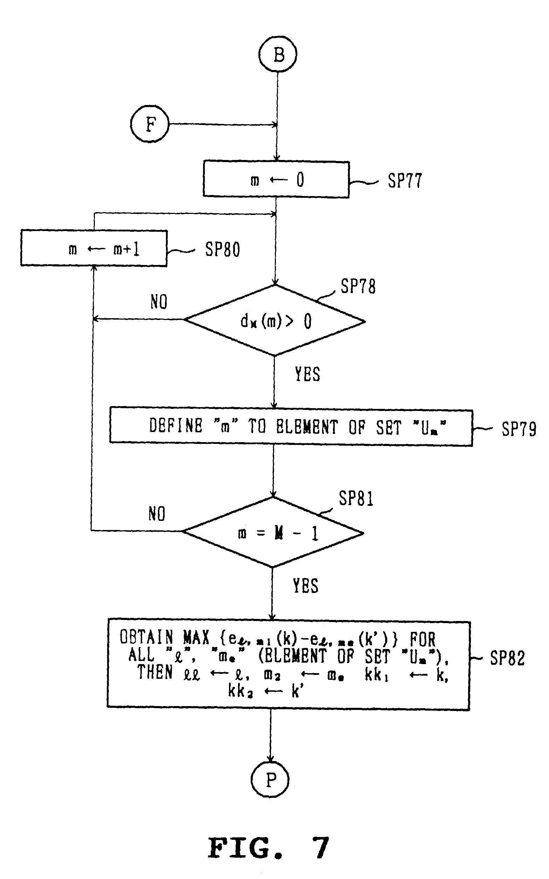

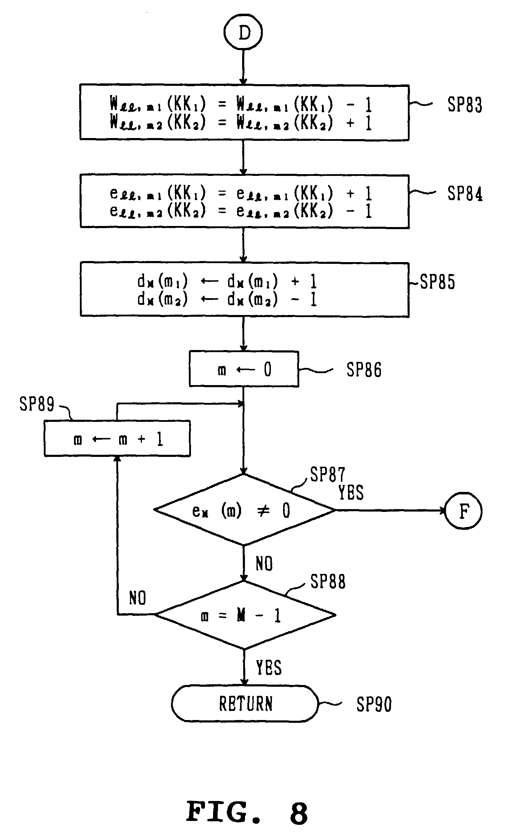

Accordingly, the CPU enters the subroutine of the third sub-filter DC gain matching processing program SP50 at the step SP3 of the magic square DC gain matching processing program SPO as shown in Fig. 4 - Fig. 8, and performs the DC gain matching regarding the coefficients of the sub-filters having non-zero element on the error sequence as follows:

At this point, assuming that the M:L conversion sub-filter DC gain matching is completed and accordingly, the non-zero element exists on the error sequence d_{M}(m). Accordingly, the CPU obtains an affirmative result at the step SP51 and moves to the next step SP52. And then, the CPU executes steps SP52 - SP55 and increments "m" in the error sequence d_{M}(m) from zero by one and, "m" at the time when the first non-zero element appears becomes "m₁" and this non-zero element becomes "d₁".

Then, the CPU judges whether the non-zero element "d₁" is positive or negative at the step SP56 and if an affirmative result is obtained, executes the steps SP57 - SP61 and defines "m" which satisfies "d_{M}(m) < 0" as the element of a set "Uₘ" in the error sequence d_{M}(m). Then the CPU executes the steps SP62 - SP65 and obtains max (e_{ℓ,m1}(k) - e_{ℓ,me}(k')) on all "ℓ" and mₑ, where the element of a set "Uₘ" is "mₑ". Where "ℓ", "mₑ", "k", "k'" having the maximum values are defined as "ℓℓ", "m₂", "kk₁", "kk₂", it is performed the following equations:${\text{W}}_{\text{ℓℓ,m1}} {\text{(kk}}_{\text{1}} {\text{) = W}}_{\text{ℓℓ,m1}} {\text{(kk}}_{\text{1}} \text{)+1}$${\text{W}}_{\text{ℓℓ,m2}} {\text{(kk}}_{\text{2}} {\text{) = W}}_{\text{ℓℓ,m2}} {\text{(kk}}_{\text{2}} \text{)-1}$${\text{e}}_{\text{ℓℓ,m1}} {\text{(kk}}_{\text{1}} {\text{) = e}}_{\text{ℓℓ,m1}} {\text{(kk}}_{\text{1}} \text{)-1}$${\text{e}}_{\text{ℓℓ,m2}} {\text{(kk}}_{\text{2}} {\text{) = e}}_{\text{ℓℓ,m2}} {\text{(kk}}_{\text{2}} \text{)+1}$${\text{d}}_{\text{M}} {\text{(m}}_{\text{1}} {\text{) = d}}_{\text{M}} {\text{(m}}_{\text{1}} \text{)-1}$${\text{d}}_{\text{M}} {\text{(m}}_{\text{2}} {\text{) = d}}_{\text{M}} {\text{(m}}_{\text{2}} \text{)+1}$

Then, the CPU executes the steps SP66 - SP69 and judges whether there are any non-zero elements exist or not in the error sequence d_{M}(m), and if non-zero element exists, the CPU returns to the step SP52 and repeats the process stated above.

Also, if the non-zero element no longer exists in the error sequence d_{M}(m), the CPU terminates the third sub-filter DC gain matching processing program SP50 at the next step SP70 and returns to the magic square DC gain matching program SP0. As a result, the CPU terminates the magic square DC gain matching processing program SP0 at the following step SP4, and thus all DC gain matching operations are terminated.

Also, if the CPU obtains a negative result at the step SP56 stated above, executes the steps SP77 - SP81 and defines "m" which satisfies "d_{M}(m) > 0" as the element of a set "Uₘ" in the error sequence d_{M}(m). Then, the CPU executes the steps SP82 - SP85 and defines the element of a set "Uₘ" as "mₑ" and obtains min (e_{ℓ,m1}(k) - e_{ℓ,me}(k')) regarding all "ℓ" and "mₑ". Furthermore, where "ℓ", "mₑ", "k", "k'" having the minimum value are defined as "ℓℓ", "m₂", "kk₁", "kk₂", the following equations can be executed:${\text{W}}_{\text{ℓℓ,m1}} {\text{(kk}}_{\text{1}} {\text{) = W}}_{\text{ℓℓ,m1}} {\text{(kk}}_{\text{1}} \text{)-1}$${\text{W}}_{\text{ℓℓ,m2}} {\text{(kk}}_{\text{2}} {\text{) = W}}_{\text{ℓℓ,m2}} {\text{(kk}}_{\text{2}} \text{)+1}$${\text{e}}_{\text{ℓℓ,m1}} {\text{(kk}}_{\text{1}} {\text{) = e}}_{\text{ℓℓ,m1}} {\text{(kk}}_{\text{1}} \text{)+1}$${\text{e}}_{\text{ℓℓ,m2}} {\text{(kk}}_{\text{2}} {\text{) = e}}_{\text{ℓℓ,m2}} {\text{(kk}}_{\text{2}} \text{)-1}$${\text{d}}_{\text{M}} {\text{(m}}_{\text{1}} {\text{) = d}}_{\text{M}} {\text{(m}}_{\text{1}} \text{)+1}$${\text{d}}_{\text{M}} {\text{(m}}_{\text{2}} {\text{) = d}}_{\text{M}} {\text{(m}}_{\text{2}} \text{)-1}$

Then, the CPU executes the steps SP86 - SP89 and judges whether any non-zero elements exist or not in the error sequence d_{M}(m) and if the non-zero element exists, returns to the step SP52 and repeats the process stated above.

Also, if no longer non-zero element exists in the error sequence d_{M}(m), it terminates the third sub-filter DC gain matching processing program SP50 at the next step SP90 and returns to the magic square DC gain matching processing program SPO. As a result, the CPU terminates said magic square DC gain matching processing program SPO at the next step SP4 and thus all DC gain matching operations are terminated.

In the case where a negative result is obtained at the step SP51, all elements of the error sequence d_{M}(m) are zeros and there exist non-zero elements in the error sequence d_{L}(ℓ) and accordingly, the same process to be described below is executed and the M:L conversion sub-filter gain matching is performed.

### (3-3) Embodiments of Magic Square DC Gain Matching Operation

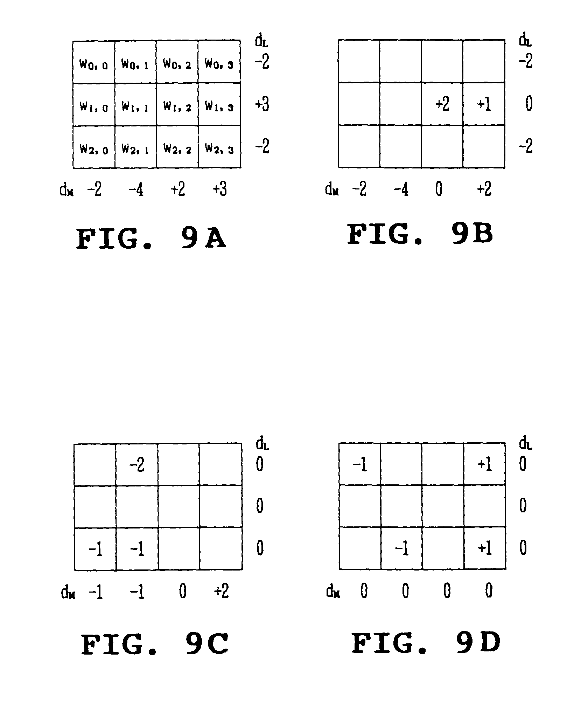

Figs. 9A to 9D shows examples of the DC gain matching operation of the sampling rate converter which performs the M:L conversion and L:M conversion in case of "M = 4" and "L = 3", and the algorithm will be explained in accordance with the embodiment of Fig. 9A as follows:

First of all, the operation of sub-filter DC gain matching processing program SP10 described above is performed; i.e., the operation for DC gain matching regarding the sub-filter which have the positive value errors from the target value is performed.

The sum totals of the positive value of error sequences d_{L}(ℓ), d_{M}(m) becomes "+3" and "+5" respectively. Since the sum totals of the above two positive value are both non-zeros, the operation is continued and since "3" has the smaller absolute value in these sum totals, then "i = 3".

Accordingly, three numbers are chosen in the order from the numbers having bigger quantization error (e_{ℓ,m}(k)) in the positive direction in the arrangement elements w_{ℓ,2}(k), w_{ℓ,3}(k) and "ℓ" will be incremented respectively. Supposing that two from w_{ℓ,2}(k) and one from w_{ℓ,3}(k) are chosen in this example. And this operation results in "d_{L}(1) = 0", "d_{M}(2) = 0", "d_{M}(3) = 2" (Fig. 9B).

Then, the second operation of the sub-filter DC gain matching processing program SP30, i.e., the operation for DC gain matching regarding the sub-filter which have the negative value errors from the target values, is performed.

At first, the total sums of error sequences d_{L}(ℓ) and d_{M}(m) become "-4" and "-6" respectively. As a result, since either of the two total sums is non-zero, the operation is continued and where "-4" the smaller absolute value, "i = 4".

Accordingly, in the arrangement elements of w_{0,0}(k), w_{0,1}(k), w_{2,0}(k), w_{2,1}(k), which satisfy "d_{L}(ℓ) < 0", "d_{M}(m) < 0", four numbers are chosen in the order from the numbers having bigger quantization error (e_{ℓ,m}(k)) in the negative direction and "ℓ" is incremented respectively. In this example, suppose that two from the arrangement elements of w_{0,1}(k), one from the arrangement elements of w_{2,0} (k) and one from the arrangement elements of w_{2,1}(k), are chosen. And this operation results in "d_{L}(0) = 0", "d_{L}(2) = 0", "d_{M}(0) = -1", "d_{M}(1) = -1" (Fig. 9C).

Lastly, the operation of the third sub-filter DC gain matching processing program SP50 will be performed. At this point, all elements of the error sequence d_{L}(ℓ) are "0", and it should be clear that the M:L conversion sub-filter DC gain matching has been completed.

Accordingly, in the error sequence d_{M}(m), "m" is incremented from zero by "1" and the first non-zero element is searched. In this example, "m₁ = 0", "d₁ = -1". Since at this point "d₁ < 0", set "m" which satisfies "d_{M}(m) > 0" as a member of a set "Uₘ" in the error sequence d_{M}(m). In this case "Uₘ = 3".

Then, where a set "Uₘ" member is "mₑ", regarding all "ℓ" and "mₑ", search for "ℓ", "mₑ", "k", "k'" which satisfy min (ee,0(k) - ee,mₑ(k')). In this example, suppose that w_{0,0}(kk₁), w_{0,3}(kk₂) are chosen. As a result, regarding said Equations (31) to (36), the following equations will be performed.${\text{w}}_{\text{0,0}} {\text{(kk}}_{\text{1}} {\text{) = w}}_{\text{0,0}} {\text{(kk}}_{\text{1}} \text{)-1}$${\text{w}}_{\text{0,3}} {\text{(kk}}_{\text{2}} {\text{) = w}}_{\text{0,3}} {\text{(kk}}_{\text{2}} \text{)+1}$${\text{e}}_{\text{0,0}} {\text{(kk}}_{\text{1}} {\text{) = e}}_{\text{0,0}} {\text{(kk}}_{\text{1}} \text{)+1}$${\text{e}}_{\text{0,3}} {\text{(kk}}_{\text{2}} {\text{) = e}}_{\text{0,3}} {\text{(kk}}_{\text{2}} \text{)-1}$${\text{d}}_{\text{M}} {\text{(0) = d}}_{\text{M}} \text{(0)+1}$${\text{d}}_{\text{M}} {\text{(3) = d}}_{\text{M}} \text{(3)-1}$

Said operation is repeated and if non-zero members no longer exist, all DC gain matching operation is terminated. In this case, if said operation is repeated once more, non-zero members no longer exist (Fig. 9D).

According to the construction as discussed above, since filter coefficients are arranged in L x M matrix with the specific rule depending on the case of L:M conversion and M:L conversion of sampling frequencies and coefficient values are operated in order that the sum totals of coefficients which exist L numbers in the direction of row are equalized and simultaneously the sum totals which exist M numbers in the direction of column are equalized, the filter coefficients wherein DC gain becomes constant both at the time of M:L conversion and L:M conversion can be obtained. Therefore, the sampling rate converter which is capable of converting sampling frequencies in two-way can be realized.

While preferred embodiments of the invention have been described, it will be obvious to those skilled in the art that various changes and modifications may be made without departing from the scope of the invention as defined in the appended claims.

## Claims

1. Sampling rate converter (1) which comprises digital filters for converting, in an L:M conversion a sampling frequency L of a digital signal to a sampling frequency M or for convening, in an M:L conversion a sampling frequency M of a digital signal to a sampling frequency L, while utilizing the same filter coefficients and maintaining a constant predetermined DC gain for both conversions, said sampling rate converter comprising:
an over-sampler (2) for multiplying said sampling frequency L or M by M or L, respectively, during said L:M conversion and said M:L conversion, respectively;
a rate converting filter (3) receiving an output of said over-sampler for restricting the frequency band of said output;
a central processing unit (CPU) for supplying filter coefficients to said rate converting filter and having means for quantizing said filter coefficients, means for arranging the quantized filter coefficients into a three-dimensional array including rows and columns, the ratio of number of rows to number of columns depending on the ratio of said first sampling frequency L and said second sampling frequency M, means for determining a ratio between a total sum of values of said rows and columns of the array of quantized filter coefficients, and means for correcting each of said quantized filter coefficients in response to the determined ratio so as to maintain said predetermined DC gain; and
a down-sampler (4) receiving an output of said rate converting filter for multiplying the rate converted frequencies.

2. The sampling rate converter of claim 1, wherein said means for correcting each of said quantized filter coefficients is further responsive to deviations of the latter from corresponding predetermined target values.

3. The sampling rate converter of claim 2, wherein the deviations of said quantized filter coefficients have either positive or negative values relative to said predetermined value on the basis of whether said quantized filter coefficients are greater than or less than said corresponding predetermined target values, respectively.

4. The sampling rate converter as in claim 3 wherein said ratio between the total sum of values of said rows and columns equals "1".

5. The sampling rate converter of claim 3, wherein said means for correcting comprises means for converting the positive values of said quantized filter coefficients to "0" values, such that said deviations are corrected.

6. The sampling rate converter of claim 3, wherein said means for correcting comprises means for converting the negative values of said quantized filter coefficients to "0" values, such that said deviations are corrected.

## Patentansprüche

1. Abtastfrequenzumsetzer (1), der Digitalfilter umfaßt, um bei einer L:M-Umsetzung eine Abtastfrequenz L eines Digitalsignals auf eine Abtastfrequenz M umzusetzen oder um bei einer M:L-Umsetzung eine Abtastfrequenz M eines Digitalsignals auf eine Abtastfrequenz L umzusetzen, wobei die gleichen Filterkoeffizienten verwendet werden und ein konstanter vorgegebener DC-Verstärkungsfaktor für beide Umsetzungen beibehalten wird, wobei der Abtastfrequenzumsetzer umfaßt:
einen Überabtaster (2) zum Multiplizieren der Abtastfrequenz L oder M mit M oder L während der L:M-Umsetzung bzw. der M:L-Umsetzung;
ein Frequenzumsetzungsfilter (3), welches ein Ausgangssignal des Überabtasters empfängt, um das Frequenzband des Ausgangssignals zu beschränken;
eine Zentralverarbeitungseinheit (CPU), um Filterkoeffizienten zum Frequenzumsetzungsfilter zu liefern, und die aufweist: eine Einrichtung, um die Filterkoeffizienten zu quantifizieren, eine Einrichtung, um die quantisierten Filterkoeffizienten in einer dreidimensionalen Matrix, die Reihen und Spalten besitzt, anzuordnen, wobei das Verhältnis der Anzahl von Reihen zur Anzahl von Spalten vom Verhältnis der ersten Abtastfrequenz L zur zweiten Abtastfrequenz M abhängig ist, eine Einrichtung, um ein Verhältnis zwischen einer Gesamtsumme von Werten der Reihen und Spalten der Matrix der quantisierten Filterkoeffizienten festzulegen, und eine Einrichtung, um jeden der quantifizierten Filterkoeffizienten in Abhängigkeit vom festgelegten Verhältnis zu korrigieren, um den vorgegebenen DC-Verstärkungsfaktor beizubehalten; und
einen Abwärts-Abtaster (4), der ein Ausgangssignal des Frequenzumsetzungsfilters empfängt, um die frequenz-umgesetzten Frequenzen zu multiplizieren.

2. Abtastfrequenzumsetzer nach Anspruch 1, wobei die Einrichtung zur Korrektur eines jeden der quantisierten Filterkoeffizienten außerdem auf Abweichungen der letzteren von den entsprechenden vorgegebenen Zielwerten anspricht.

3. Abtastfrequenzumsetzer nach Anspruch 2, wobei die Abweichungen der quantisierten Filterkoeffizienten entweder positive oder negative Werte in bezug auf den vorgegebenen Wert haben, auf der Basis, ob die quantisierten Filterkoeffizienten größer oder kleiner sind als die entsprechenden vorgegebenen Zielwerte.

4. Abtastfrequenzumsetzer nach Anspruch 3, wobei das Verhältnis zwischen der Gesamtsumme von Werten der Reihen und Spalten gleich "1" ist.

5. Abtastfrequenzumsetzer nach Anspruch 3, wobei die Einrichtung zur Korrektur eine Einrichtung umfaßt, um die positiven Werte der quantisierten Filterkoeffizienten auf "0"-Werte umzusetzen, so daß die Abweichungen korrigiert sind.

6. Abtastfrequenzumsetzer nach Anspruch 3, wobei die Einrichtung zur Korrektur eine Einrichtung umfaßt, um die negativen Werte der quantisierten Filterkoeffizienten auf "0" - Werte umzusetzen, so daß die Abweichungen korrigiert sind.

## Revendications

1. Convertisseur de fréquence d'échantillonnage (1) qui comporte des filtres numériques pour convertir, dans une conversion L:M, une fréquence d'échantillonnage L d'un signal numérique en une fréquence d'échantillonnage M ou pour convertir, dans une conversion M:L, une fréquence d'échantillonnage M d'un signal numérique en une fréquence d'échantillonnage L, tout en utilisant les mêmes coefficients de filtre et en maintenant constant un gain en continu prédéterminé pour les deux conversions, ledit convertisseur de fréquence d'échantillonnage comportant :
un suréchantillonneur (2) pour multiplier ladite fréquence d'échantillonnage L ou M par M ou L, respectivement, durant ladite conversion L:M et ladite conversion M:L, respectivement ;
un filtre de conversion de fréquence (3) recevant un signal de sortie dudit suréchantillonneur pour limiter la bande de fréquence dudit signal de sortie ;
une unité de traitement centrale (CPU) pour délivrer des coefficients de filtre audit filtre de conversion de fréquence et possédant des moyens afin de quantifier lesdits coefficients de filtre, des moyens pour disposer les coefficients de filtre quantifiés en un réseau tridimensionnel comprenant des rangées et des colonnes, le rapport du nombre de rangées au nombre de colonnes dépendant du rapport de ladite première fréquence d'échantillonnage L et de ladite seconde fréquence d'échantillonnage M, des moyens pour déterminer un rapport entre une somme totale de valeurs desdites rangées et colonnes du réseau de coefficients de filtre quantifiés, et des moyens pour corriger chacun desdits coefficients de filtre quantifiés en réponse au rapport déterminé de manière à maintenir constant ledit gain en continu prédéterminé ; et
un sous-échantillonneur (4) recevant un signal de sortie dudit filtre de conversion de fréquence pour multiplier les fréquences converties.

2. Convertisseur de fréquence d'échantillonnage selon la revendication 1, dans lequel lesdits moyens de correction de chacun desdits coefficients de filtre quantifiés sont en outre sensibles à des écarts de celui-ci vis-à-vis de valeurs cibles prédéterminées correspondantes.

3. Convertisseur de fréquence d'échantillonnage selon la revendication 2, dans lequel les écarts desdits coefficients de filtre quantifiés possèdent, soit des valeurs positives, soit des valeurs négatives par rapport à ladite valeur prédéterminée en fonction desquelles lesdits coefficients de filtre quantifiés sont supérieurs ou inférieurs auxdites valeurs cibles prédéterminées correspondantes, respectivement.

4. Convertisseur de fréquence d'échantillonnage selon la revendication 3, dans lequel ledit rapport entre la somme totale de valeurs desdites rangées et colonnes est égal à "1".

5. Convertisseur de fréquence d'échantillonnage selon la revendication 3, dans lequel lesdits moyens de correction comportent des moyens afin de convertir les valeurs positives desdits coefficients de filtre quantifiés à des valeurs "0", de manière à corriger lesdits écarts.

6. Convertisseur de fréquence d'échantillonnage selon la revendication 3, dans lequel lesdits moyens de correction comportent des moyens afin de convertir les valeurs négatives desdits coefficients de filtre quantifiés à des valeurs "0", de manière à corriger lesdits écarts.
